# EUROPÄISCHE PATENTSCHRIFT

(11) **EP 2 359 419 B1**
(45) Veröffentlichungstag und Bekanntmachung des Hinweises auf die Patenterteilung: **09.01.2013**
(21) Anmeldenummer: 09752844.2
(22) Anmeldetag: 19.11.2009
(51) Int. Cl.: H01L 41/047

(54) **VIELSCHICHTAKTOR MIT AUSSENELEKTRODEN ALS METALLISCHE, PORÖSE, DEHNBARE LEITSCHICHT**
MULTI-LAYERED ACTUATOR WITH EXTERNAL ELECTRODES MADE OF A METALLIC, POROUS, EXPANDABLE CONDUCTIVE LAYER
ACTIONNEUR MULTICOUCHE AVEC ÉLECTRODES EXTERNES FORMANT UNE COUCHE CONDUCTRICE MÉTALLIQUE, POREUSE ET EXTENSIBLE

(30) Priorität: 20.11.2008 DE 102008043912; 25.06.2009 DE 102009027192
(43) Veröffentlichungstag der Anmeldung: 24.08.2011
(73) Patentinhaber: CeramTec GmbH, 73207 Plochingen (DE)
(72) Erfinder: BINDIG, Reiner, 95463 Bindlach (DE)
(74) Vertreter: Scherzberg, Andreas Hans
(86) Internationale Anmeldenummer: PCT/EP2009/065433
(87) Internationale Veröffentlichungsnummer: WO 2010/057939

(56) Entgegenhaltungen:
- DE-A1-102004 042 373
- JP-A- 7 050 435
- US-A1- 2007 080 612

## Beschreibung

Die Erfindung betrifft einen monolithischen Vielschichtaktor aus einem gesinterten Stapel dünner Folien aus Piezokeramik mit eingelagerten metallischen Innenelektroden, wobei alle Innenelektroden einer Polarität durch eine auf dem Stapel aufgebrachte Grundmetallisierung elektrisch parallel geschaltet sind und zur elektrischen Kontaktierung mit der Grundmetallisierung eine Außenelektrode elektrisch leitend verbunden ist.

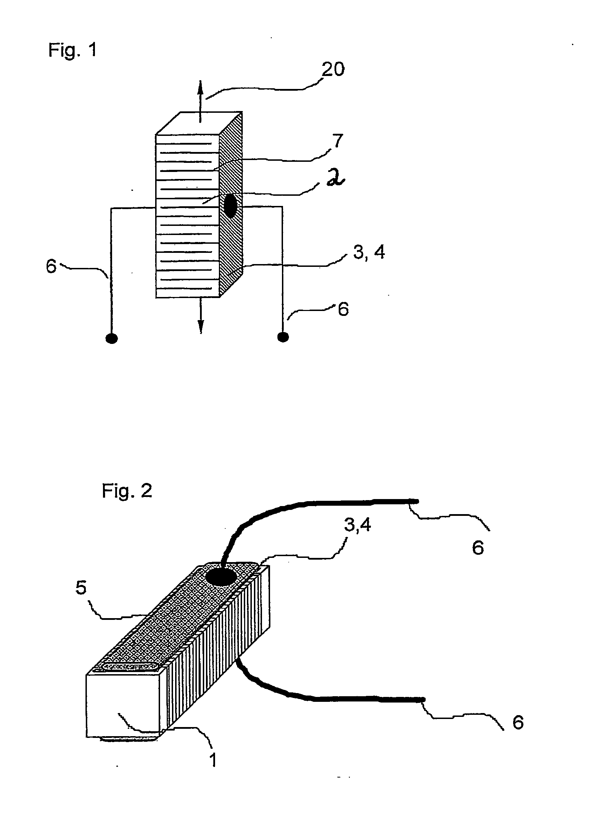

Piezokeramische Vielschichtaktoren (siehe Figuren 1, 2 und 3) bestehen aus gestapelten dünnen Schichten piezoelektrisch aktiven Materials 2, z. B. Blei-Zirkonat-Titanat (PZT), mit dazwischen angeordneten leitfähigen Innenelektroden 7, die alternierend an die Aktoroberfläche geführt werden. Grundmetallisierungen 3, 4 verbinden diese Innenelektroden 7. Dadurch werden die Innen-elektroden elektrisch parallel geschaltet und zu z w e i Gruppen zusammengefasst, welche die beiden Anschlusspole des Aktors darstellen. Legt man eine elektrische Spannung an die Anschlusspole, so wird diese auf alle Innen-elektroden parallel übertragen und verursacht ein elektrisches Feld in allen Schichten aktiven Materials, das sich dadurch mechanisch verformt. Die Summe aller dieser mechanischen Verformungen steht an den Endflächen des Aktors als nutzbare Dehnung und/oder Kraft 20 zur Verfügung.

Piezokeramische Vielschichtaktoren werden nach dem Stand der Technik als Monolithen ausgeführt, dass heißt, das aktive Material 2 wird als so genannte Grün-Folie vor dem Sintern durch ein Siebdruckverfahren mit Innenelektroden versehen, zu Aktorstapeln verpresst, pyrolysiert und dann gesintert, wodurch der monolithische Aktor entsteht.

Auf den Aktorstapel 1 wird im Bereich der herausgeführten Innenelektroden 7 zum Beispiel durch galvanische Verfahren oder Siebdruck von Metallpaste eine Grundmetallisierung 3, 4 aufgebracht. Diese Grundmetallisierung 3, 4 wird verstärkt durch Aufbringen einer Außenelektrode 5 je Grundmetallisierung aus einem metallischen Werkstoff z. B. durch Anlöten eines strukturierten Bleches oder eines Drahtnetzes. An diese Außenelektrode 5 werden die elektrischen Anschlussdrähte 6 gelötet.

Der Aufbau und die Herstellung derartiger Vielschichtaktoren und Außenelektroden wird ausführlich beschrieben z. B. in WO 98/20721, US 5 281 885, US 4 845 399, US 5 406 164 und JP 07-226541 A.

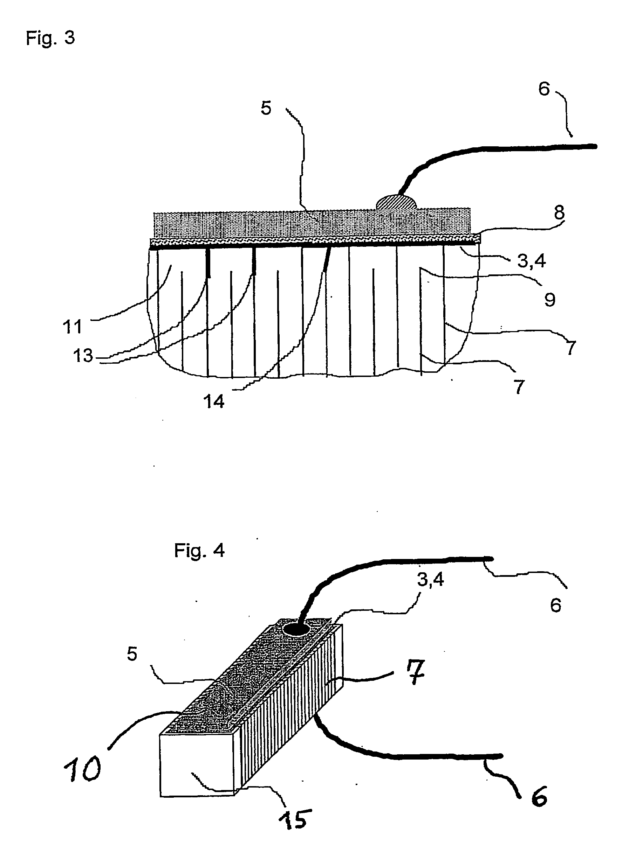

Derart aufgebaute Aktoren weisen einen Nachteil auf: Während des Betriebes wirken auf den Isolierbereich 11 (siehe Figur 3), der unter der Grundmetallisierung 3, 4 liegt, starke Zugspannungen. Da dieser Isolierbereich 11 zusammen mit der Grundmetallisierung 3, 4 eine homogene Einheit bildet, versagt diese beim Überschreiten der Zugfestigkeit des schwächsten Gliedes, es bildet sich ein Riss. Die Risse beginnen in den Bereichen maximaler Zugspannung 9 und laufen Richtung Grundmetallisierung 3, 4. Mehrere dieser typischen Risse 13, 14 sind in Fig. 3 dargestellt.

Damit diese Risse die stromtragende Schicht bzw. die Außenelektroden 5 nicht durchtrennen, was zum Ausfall des Bauteils führen würde, muss diese Schicht dehnbar gemacht werden, zum Beispiel indem man sie entsprechend strukturiert ausführt. Diese Vorgehensweise ist in EP 0 844 678 A1 oder WO 98/20721 detailliert beschrieben.

Grundlage dieser Vorgehensweisen sind jeweils komplex strukturierte Metallteile (Bleche, Drähte, Gewebe) als Außenelektrode, die auf die Grundmetallisierung durch Löten oder Kleben elektrisch leitfähig aufgebacht werden.

Nachteilig ist, dass diese Metallteile kostenaufwändig hergestellt werden müssen und durch einen teueren und technisch extrem anspruchsvollen und fehleranfälligen Prozess an der Grundmetallisierung angebracht werden müssen.

Ein weiteres Beispiel ist in US 2007/0080612 beschrieben.

Der Erfindung liegt die Aufgabe zugrunde, einen monolithischen Vielschichtaktor nach dem Oberbegriff des Anspruchs 1 so zu verbessern, dass die Außenelektrode mit einfachen und kostengünstigen Mitteln auf die Grundmetallisierung aufzubringen ist und so dehnbar ist, dass sie die Rissenergie im Aktor entstehender Risse abbaut ohne dabei durchtrennt zu werden. Außerdem soll ein Verfahren zur Herstellung eines derartigen Vielschichtaktors angegeben werden.

Erfindungsgemäß wird diese Aufgabe bezüglich des Vielschichtaktors durch die Merkmale des Anspruchs 1 gelöst.

Dadurch, dass die Außenelektrode eine metallische, poröse, dehnbare Leitschicht ist, die aus zusammengesinterten Metallpartikeln besteht und auf die Grundmetallisierung aufgebracht ist, können Risse, die aus dem Aktorkörper durch die Grundmetallisierung in die Leitschicht verlaufen, diese nicht durchtrennen, da die Rissenergie an den Rissspitzen im porösen Gefüge der Leitschicht abgebaut wird.

Erfindungsgemäß sind die Metallpartikel kugel förmig ausgebildet. Fadenförmige Metallpartikel ergeben beim Versintern eine filzartige Struktur, die extrem dehnbar ist, weil mechanische Spannungen in Drehbewegungen umgewandelt werden.

Die Grundmetallisierung, die für die Haftfestigkeit auf dem Keramikkörper sorgt und zugleich der Träger der Leitschicht ist, muss geeignet ausgewählt werden.

Bevorzugt besteht der Metallanteil der Grundmetallisierung aus Silber oder einer Silberlegierung und sind der Grundmetallisierung ein oder mehrere glasbildende Substanzen beigemischt. In einer bevorzugten Ausführungsform sind die glasbildenden Substanzen PbO, BiO₂ oder SiO₂ da diese in den PZT Keramiken keine Eigenschaftsänderungen hervorrufen.

Die Metallpartikel der Leitschicht bestehen bevorzugt aus Silber, Kupfer, einer Silberlegierung oder einer Kupferlegierung, wobei folgende Materialien besonders bevorzugt sind: Ag, AgPd mit bis zu 30 % Pd Anteil, Cu, CuNi mit bis zu 50 % Ni Anteil. CuNi Legierungen sind beständiger gegen Oxidation als die reinen Metalle und können mit einfacheren und kostengünstigeren Verfahren versintert werden.

Die kugelförmigen Metallpartikel der Leitschicht weisen einen Durchmesser von 1 - 100 µm auf, wobei nur der Bereich von 10 - 50 µm Teil der Erfindung ist. Hierdurch ist die Porosität ausreichend um die Rissenergie abzubauen.

Als Beispiel, das nicht Teil der Erfindung ist, können zur Verstärkung in die Leitschicht fadenförmige Metallpartikel mit einem Durchmesser von 5 - 20 µm und einer Länge von 0,1 - 0,5 mm enthalten sein, wobei der Anteil der fadenförmigen Partikel 1 -100 % der Leitschicht beträgt.

Zur Verstärkung kann in die Leitschicht auch ein Metalldrahtgewebe eingebettet sein, wobei das Metalldrahtgewebe bevorzugt aus dem gleichen Metall wie die Metallpartikel der Leitschicht besteht.

In bevorzugter Ausführungsform weist die Leitschicht eine Dicke von 0,01 - 1 mm aufweist, wobei der Bereich von 0,1 - 0,3 mm besonders bevorzugt ist. Bei diesen Dicken traten die wenigsten Ausfälle der Aktoren auf.

Ein Verfahren zur Herstellung eines monolithischen Vielschichtaktors aus einem gesinterten Stapel dünner Folien aus Piezokeramik mit eingelagerten metallischen Innenelektroden, wobei alle Innenelektroden einer Polarität durch eine auf dem Stapel aufgebrachte Grundmetallisierung elektrisch parallel geschaltet werden und zur elektrischen Kontaktierung mit der Grundmetallisierung eine Außenelektrode elektrisch leitend verbunden wird, insbesondere zur Herstellung eines erfindungsgemäßen Vielschichtaktors ist erfindungsgemäß dadurch gekennzeichnet, dass als Außenelektrode auf die Grundmetallisierung eine Paste mit insbesondere kugel- und/oder fadenförmigen Metallpartikeln aufgebracht und eingebrannt wird, wobei die Paste bei einer Temperatur eingebrannt wird, die ausreicht, ein Zusammensintern der Metallpartikel auszulösen, jedoch niedrig genug ist, eine Verdichtung der Metallpartikel zu einem Festkörper zu vermeiden, so dass beim Einbrennvorgang die Paste in eine metallische, poröse, dehnbare Leitschicht übergeht, die aus zusammengesinterten Metallpartikeln besteht.

Bevorzugt wird die Paste mittels Schablonendrucktechnik auf die Grundmetallisierung aufgebracht. Mit dieser Auftragstechnik können die bevorzugten Schichtdicken 0,1 - 0,3 mm problemlos erzeugt werden. Die aufgebrachte Paste wird dann getrocknet und bei höheren Temperaturen zusammengesintert damit sie eine metallische, poröse, dehnbare und ausreichend stromtragfähige Leitschicht bildet.

In bevorzugter Ausführungsform wird als Paste eine Mischung aus Metallpartikeln mit organischen Bindern und Lösungsmitteln verwendet, wobei für die Paste keine Glasbildner verwendet werden da diese die versinterte Leitschicht verspröden würden und deren Stromtragfähigkeit reduzieren würden.

Bevorzugt werden für die Paste kugelförmige Metallpartikel mit einem Durchmesser von 1 - 100 µm, bevorzugt von 10 - 50 µm verwendet da diese besonders geeignet sind, die Rissenergie abzubauen.

Als Beispiel, das nicht Teil der Erfindung ist, können zur Verstärkung in die Paste fadenförmige Metallpartikel mit einem Durchmesser von 5 - 20 µm und einer Länge von 0,1-0,5 mm eingebettet werden, wobei die fadenförmigen Metallpartikel 1 - 100 % des Metallanteils der Paste ausmachen.

Zur Verstärkung wird in einer anderen Ausführungsform in die Paste zumindest ein Metalldrahtgewebe eingebettet, wobei das Metalldrahtgewebe bevorzugt aus dem gleichen Metall wie die Metallpartikel der Paste besteht.

In Weiterbildung der Erfindung wird die Stelle auf der Leitschicht, an die später zur elektrischen Kontaktierung ein Zuleitungsdraht angelötet werden soll, zumindest oberflächlich verdichtet.

An Aktoren mit derart ausgeführten Außenelektroden können so elektrische Kontaktierungen an jeder Stelle der Außenelektrode durch Löten angebracht werden, ohne dass dies einen Einfluss auf die Lebensdauer oder sonstige Eigenschaften des Aktors hat. Es muss lediglich verhindert werden, dass das verwendete Lot die Leitschicht durchdringt und unterwandert. Dies gelingt indem man die Leitschicht an der Lötstelle oberflächlich verdichtet und die Lötzeit auf wenige Sekunden beschränkt.

Die Leitschicht wird an der gewünschten Lötstelle verdichtet, indem man bevorzugt ein Stahlwerkzeug lateral über die Oberfläche bewegt. An diese Stelle wird mit einem geeigneten Lot (Sn-Legierung) ein Lötpunkt angebracht, an dem später der Zuleitungsdraht angelötet wird. Es sind auch andere Verbindungstechniken denkbar wie z.B. Drahtbonden oder Schweißen.

Die Dicke der Leitschicht kann leicht durch die Druckschablone eingestellt werden. Die minimale Dicke richtet sich nach dem Aktortyp, dessen spezifischen Dehnung und damit der Laufweite der Risse in der Leitschicht (etwa 50 µm). Die maximale Dicke dagegen wird durch den Strombedarf des Aktors festgelegt und kann bis über 0,5 mm betragen.

Nachfolgend wird das Verfahren weiter beschrieben:

Eine niedrig sinternde Piezokeramik, z. B. nach DE 198 40 488 wird mit einem organischen Bindersystem als 125 µm dicke Folie präpariert. Auf diese Folie wird Innenelektrodenpaste aus Silber-Palladium Pulver in Gewichtsverhältnis 70/30 und einem geeigneten Bindersystem mittels Siebdruck aufgebracht. Eine Vielzahl derartiger Folien wird gestapelt und zu einem Laminat verpresst. Das Laminat wird zu einzelnen, stabförmigen Aktoren zertrennt, diese werden bei ca. 500°C pyrolysiert und bei ca. 1000 °C gesintert. Anschließend werden die Aktorgrundkörper an allen Seiten mechanisch bearbeitet.

Die Grundmetallisierung aus z.B. einer geeigneten Silber oder Silber-Palladium Terminierungspaste wird mittels eines Siebdruckprozesses auf die Kontaktseiten aufgebracht und eingebrannt. Dabei schmilzt der in der Paste vorhandene Glasbildner und verbindet die zusammensinternden metallischen Anteile der Paste haftfest mit dem Keramikgrundkörper.

Auf die Grundmetallisierung wird nun mittels z. B. Schablonendruck eine dickere Schicht Paste (z. B 0,2 mm dick) aufgebracht, die aus relativ grobkörnigen Metallpartikeln, (z.B. 80 % kugelförmigen Silberpartikeln mit 20 µm Durchmesser und 20% fadenförmigen Silberpartikeln mit einem Durchmesser von 20 µm und einer Länge von 0,3 mm) organischen Bindern und Lösungsmitteln besteht. Diese Schicht enthält keinen Glasbildner da dieser die Leitschicht verspröden und deren Stromtragfähigkeit reduzieren würde.

Die Paste wird nun bei einer Temperatur eingebrannt, die ausreicht, ein Zusammensintern der Metallpartikel auszulösen, jedoch niedrig genug ist, eine Verdichtung der Partikel zu einem Festkörper zu vermeiden (bei Silber z.B. 700°C, abhängig von der verwendeten Korngröße).

Die Leitschicht wird nun an der gewünschten Lötstelle verdichtet, indem man ein Stahlwerkzeug lateral über die Oberfläche bewegt. An diese Stelle wird mit einem geeigneten Lot (Sn-Legierung) ein Lötpunkt angebracht, an dem später der Zuleitungsdraht angelötet wird. Es sind jederzeit auch andere Verbindungstechniken denkbar wie z.B. Drahtbonden oder Schweißen.

Es ist auch möglich, die Kontaktierung erst nach dem Lackieren anzubringen, wobei dann der Löt- oder Schweißbereich in der Regel lackfrei gehalten werden muss.

Die Aktoren werden anschließend durch eine Lackschicht geschützt.

Die Aktoren können nun polarisiert und elektrisch gemessen werden.

### Beschreibung der Zeichnungen:

- Figur 1: zeigt schematisch den Aufbau eines monolithischen Vielschichtaktors.
- Figur 2: zeigt einen Aktor mit weiteren Details nach dem Stand der Technik
- Figur 3: zeigt einen Ausschnitt des Aktors mit den typischen Rissen, die sich nach ca. 10⁶ Belastungszyklen einstellen. (Figuren 1 bis 3 zeigen den Stand der Technik.)
- Figur 4: zeigt einen Aktor mit Grundmetallisierung und Leitschicht gemäß dieser Erfindung.
- Figur 5: zeigt eine schematische Vergrößerung (Schnitt) eines Aktors gemäß dieser Erfindung mit Darstellung der Metallpartikel in der Leitschicht.

In den Figuren 1 bis 3 ist ein Vielschichtaktor nach dem Stand der Technik gezeigt. In der Beschreibungseinleitung sind diese Figuren näher erläutert

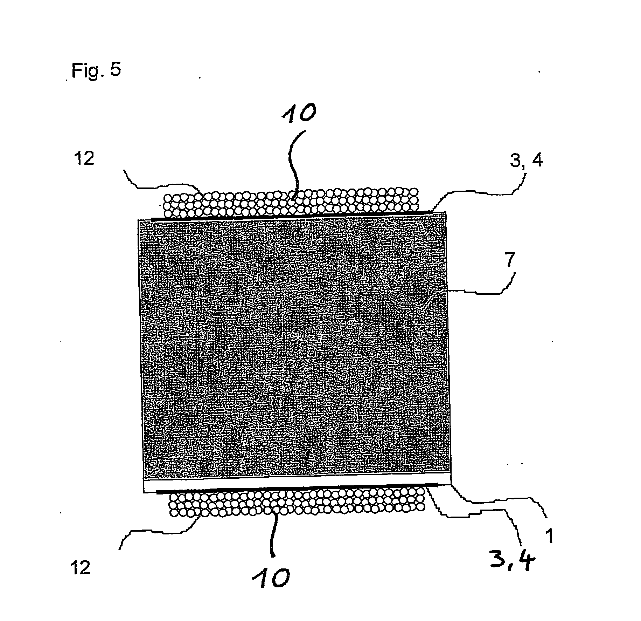

Die Figuren 4 und 5 zeigen einen erfindungsgemäßen Vielschichtaktor aus einem gesinterten Stapel dünner Folien aus Piezokeramik mit eingelagerten metallischen Innenelektroden 7. Die Innenelektroden 7 einer Polarität sind durch eine auf dem Stapel aufgebrachte Grundmetallisierung 3, 4 elektrisch parallel geschaltet. Zur elektrischen Kontaktierung ist mit der Grundmetallisierung 3, 4 eine Außenelektrode 5 elektrisch leitend verbunden.

Erfindungsgemäß ist diese Außenelektrode 5 eine metallische, poröse, dehnbare Leitschicht 10, die aus zusammengesinterten kugel- und/oder fadenförmigen Metallpartikeln 12 besteht. Figur 5 zeigt schematisch diese Leitschicht 10 als einzelne Kreise, die die einzelnen Metallpartikel 12 symbolisieren sollen. Wichtig ist hierbei, dass die Paste bzw. die sich darin befindlichen Metallpartikel 12 bei einer Temperatur eingebrannt werden, die ausreicht, ein Zusammensintern der Metallpartikel 12 auszulösen, jedoch niedrig genug ist, eine Verdichtung der Metallpartikel 12 zu einem Festkörper zu vermeiden, so dass beim Einbrennvorgang die Metallpartikel in eine metallische, poröse, dehnbare Leitschicht 10 übergehen. Unter Festkörper wird hier ein Körper ohne innere Hohlräume und mit einer geschlossenen Oberfläche verstanden. Dieser wäre nicht porös und nicht dehnbar.

Man kann sich diese Leitschicht 10 als einen Schwamm oder Filz mit inneren Hohlräumen und einer offenporigen Oberfläche vorstellen. Die Leitschicht 10 ist daher über nur partielle Kontaktstellen mit der Grundmetallisierung 3, 4 verbunden und hebt zwischen den Kontaktstellen von der Grundmetallisierung 3, 4 ab. Dadurch ist die Leitschicht 10 zwischen den Kontaktstellen dehnbar und kann die im Aktor entstandene Rissenergie aufnehmen, ohne dass es zu einem Abreißen der elektrischen Verbindung und dadurch zu einem Ausfall des Aktors kommt.

Hergestellt wird diese Leitschicht 10 aus einer Paste, die eine Mischung aus kugel- und/oder fadenförmigen Metallpartikeln 12 mit organischen Bindern und Lösungsmitteln ist. Diese Paste wird auf die Grundmetallisierung 3, 4 mittels Siebdruck- oder Schablonendrucktechnik aufgebracht und durch gezielte Energiezufuhr eingebrannt. Dieses Verfahren ist im Einzelnen weiter oben beschrieben.

## Patentansprüche

1. Monolithischer Vielschichtaktor (15) aus einem gesinterten Stapel dünner Folien aus Piezokeramik mit eingelagerten metallischen Innenelektroden (7), wobei alle Innenelektroden einer Polarität durch eine auf dem Stapel aufgebrachte Grundmetallisierung (3, 4) elektrisch parallel geschaltet sind und zur elektrischen Kontaktierung mit der Grundmetallisierung (3, 4) eine Außenelektrode (5) elektrisch leitend verbunden ist, wobei die Außenelektrode (5) eine metallische, poröse, dehnbare Leitschicht (10) ist, die aus zusammengesinterten Metall-partikeln (12) besteht und auf die Grundmetallisierung (3, 4) aufgebracht ist,
**dadurch gekennzeichnet, dass** die Metallpartikel kugel förmig ausgebildet sind und die kugelförmigen Metalpartikel (12) der Leitschicht (10) einen Durchmesser von 10 - 50 µm aufweisen.

2. Vielschichtaktor nach Anspruch 1, **dadurch gekennzeichnet, dass** der Metallanteil der Grundmetallisierung (3, 4) aus Silber oder einer Silberlegierung besteht und der Grundmetallisierung (3, 4) ein oder mehrere glasbildende Substanzen beigemischt sind.

3. Vielschichtaktor nach Anspruch 1 oder 2, **dadurch gekennzeichnet, dass** die glasbildenden Substanzen PbO, BiO₂ oder SiO₂ sind.

4. Vielschichtaktor nach einem der vorhergehenden Ansprüche, **dadurch gekennzeichnet, dass** die Metallpartikel (12) der Leitschicht (5) aus Silber, Kupfer, einer Silbedegierung oder einer Kupferlegierung bestehen, wobei folgende Materialien besonders bevorzugt sind: Ag, AgPd mit bis zu 30 % Pd Anteil, Cu, CuNi mit bis zu 50 % Ni Anteil.

5. Vielschichtaktor nach einem der vorhergehenden Ansprüche, **dadurch gekennzeichnet, dass** in die Leitschicht (10) ein Metalldrahtgewebe eingebettet ist, wobei das Metalldrahtgewebe bevorzugt aus dem gleichen Metall wie die Metallpartikel (12) der Leitschicht (10) besteht.

6. Vielschichtaktor nach einem der vorhergehenden Ansprüche, **dadurch gekennzeichnet, dass** die Leitschicht (10) eine Dicke von 0,01 - 1 mm aufweist, wobei der Bereich von 0,1 - 0,3 mm besonders bevorzugt ist.

7. Verfahren zur Herstellung eines monolithischen Vielschichtaktors (15) aus einem gesinterten Stapel dünner Folien aus Piezokeramik mit eingelagerten metallischen Innenelektroden (7), wobei alle Innenelektroden (7) einer Polarität durch eine auf dem Stapel aufgebrachte Grundmetallisierung (3, 4) elektrisch parallel geschaltet werden und zur elektrischen Kontaktierung mit der Grundmetallisierung (3, 4) eine Außenelektrode (5) elektrisch leitend verbunden wird, zur Herstellung eines Vielschichtaktors (15) nach einem der Ansprüche 1 bis 7, **dadurch gekennzeichnet, dass** als Außenelektrode (5) auf die Grundmetallisierung (3, 4) eine Paste mit kugelförmigen Metallpartikeln (12) aufgebracht und eingebrannt wird und für die Paste kugelförmige Metallpartikel (12) mit einem Durchmesser von 10 - 50 µm verwendet werden, wobei die Paste bei einer Temperatur eingebrannt wird, die ausreicht, ein Zusammensintern der Metallpartikel (12) auszulösen, jedoch niedrig genug ist, eine Verdichtung der Metallpartikel (12) zu einem Festkörper zu vermeiden, so dass beim Einbrennvorgang die Paste in eine metallische, poröse, dehnbare Leitschicht (10) übergeht, die aus zusammengesinterten Metallpartikeln (12) besteht-.

8. Verfahren nach Anspruch 8, **dadurch gekennzeichnet, dass** die Paste mittels Schablonendrucktechnik auf die Grundmetallisierung (3, 4) aufgebracht wird.

9. Verfahren nach Anspruch 8 oder 9, **dadurch gekennzeichnet, dass** als Paste eine Mischung aus kugel förmigen Metallpartikeln (12) mit organischen Bindern und Lösungsmitteln verwendet wird, wobei für die Paste keine Glasbildner verwendet werden.

10. Verfahren nach einem der Ansprüche 8 bis 11, **dadurch gekennzeichnet, dass** in die Paste zumindest ein Metalldrahtgewebe eingebettet wird, wobei das Metalldrahtgewebe bevorzugt aus dem gleichen Metall wie die Metallpartikel (12) der Paste besteht.

11. Verfahren nach einem der Ansprüche 8 bis 12, **dadurch gekennzeichnet, dass** die Stelle auf der Leitschicht (10), an die später zur elektrischen Kontaktierung ein Zuleitungsdraht (6) angelötet werden soll, zumindest oberflächlich verdichtet wird.

## Claims

1. A monolithic multi-layered actuator (15) from a sintered stack of thin films of piezoceramic, with incorporated metallic internal electrodes (7), in which all internal electrodes of one polarity are electrically connected in parallel by base metallisation (3, 4) which is deposited on the stack, and for electrical contacting an external electrode (5) is connected in an electrically conductive manner to the base metallisation (3, 4), wherein the external electrode (5) is a metallic, porous, expandable conductive layer (10), which consists of metallic particles (12) sintered together and is deposited on the base metallisation (3, 4), **characterized in that** the metallic particles are of spherical shape, and the spherical metallic particles (12) of the conductive layer (10) have a diameter of 10 to 50 µm.

2. A multi-layered actuator according to claim 1, **characterized in that** the metallic part of the base metallisation (3, 4) consists of silver or a silver alloy, and one or more glass-forming substances are mixed into the base metallisation (3, 4).

3. A multi-layered actuator according to claim 1 or 2, **characterized in that** the glass-forming substances are PbO, BiO₂ or SiO₂.

4. A multi-layered actuator according to any one of the preceding claims, **characterized in that** the metallic particles (12) of the conductive layer (5) consist of silver, copper, a silver alloy or a copper alloy, the following materials being specially preferred: Ag, AgPd with the proportion of Pd being up to 30%, Cu, CuNi with the proportion of Ni being up to 50%.

5. A multi-layered actuator according to any one of the preceding claims, **characterized in that** a metallic wire fabric is embedded in the conductive layer (10), the metallic wire fabric preferably consisting of the same metal as the metallic particles (12) of the conductive layer (10).

6. A multi-layered actuator according to any one of the preceding claims, **characterized in that** the conductive layer (10) has a thickness of 0.01 to 1 mm, the range of 0.1 to 0.3 mm being specially preferred.

7. A method of producing a monolithic multi-layered actuator (15) from a sintered stack of thin films of piezoceramic, with incorporated metallic internal electrodes (7), in which all internal electrodes (7) of one polarity are electrically connected in parallel by base metallisation (3, 4) which is deposited on the stack, and for electrical contacting an external electrode (5) is connected in an electrically conductive manner to the base metallisation (3, 4), for producing a multi-layered actuator (15) according to any one of claims 1 to 7, **characterized in that** as the external electrode (5), a paste with spherical metallic particles (12) is deposited on the base metallisation (3, 4) and baked in, and spherical metallic particles (12) with a diameter of 10 to 50 µm are used for the paste, the paste being baked in at a temperature which is sufficient to initiate sintering of the metallic particles (12) together, but low enough to avoid compressing the metallic particles (12) into a solid body, so that in the baking-in process the paste is transformed into a metallic, porous, expandable conductive layer (10) consisting of metallic particles (12) sintered together.

8. A method according to claim 8, **characterized in that** the paste is deposited on the base metallisation (3, 4) by means of stencil printing.

9. A method according to claim 8 or 9, **characterized in that** a mixture of spherical metallic particles (12) with organic binders and solvents is used as the paste, with no glass formers being used for the paste.

10. A method according to any one of claims 8 to 11, **characterized in that** at least one metallic wire fabric is embedded in the paste, the metallic wire fabric preferably consisting of the same metal as the metallic particles (12) of the paste.

11. A method according to any one of claims 8 to 12, **characterized in that** the location on the conductive layer (10) at which a lead wire (6) is to be soldered on later for electrical contacting is compressed at least superficially.

## Revendications

1. Actionneur multicouche monolithique (15) constitué d'un empilage fritté de feuilles minces en piézocéramique, comportant des électrodes intérieures métalliques incorporées (7), toutes les électrodes intérieures d'une polarité étant électriquement branchées en parallèle au moyen d'une métallisation de base (3, 4) appliquée sur l'empilage et une électrode extérieure (5) étant reliée de façon électriquement conductrice en vue du contact électrique avec la métallisation de base (3, 4), l'électrode extérieure (5) étant une couche conductrice (10), métallique, poreuse et ductile, qui est constituée de particules métalliques (12) frittées ensemble et qui est appliquée sur la métallisation de base (3, 4), **caractérisé en ce que** les particules métalliques ont une forme sphérique et **en ce que** les particules métalliques de forme sphérique (12) de la couche conductrice (10) présentent un diamètre de 10 à 50 micromètres.

2. Actionneur multicouche selon la revendication 1 **caractérisé en ce que** la partie métallique de la métallisation de base (3, 4) est constituée d'argent ou d'un alliage d'argent et **en ce que** une ou plusieurs substances susceptibles de former du verre sont mélangées à la métallisation de base (3, 4).

3. Actionneur multicouche selon la revendication 1 ou 2 **caractérisé en ce que** les substances susceptibles de former du verre sont le PbO, le BiO₂ ou le SiO₂.

4. Actionneur multicouche selon une des revendications qui précèdent **caractérisé en ce que** les particules métalliques (12) de la couche conductrice (5) sont constituées d'argent, de cuivre, d'un alliage d'argent ou d'un alliage de cuivre, les matériaux suivants étant particulièrement préférés : Ag, AgPd doté d'une teneur en Pd allant jusqu'à 30 %, Cu, CuNi doté d'une teneur en Ni allant jusqu'à 50 %.

5. Actionneur multicouche selon une des revendications qui précèdent **caractérisé en ce qu'**un tissu de fils métalliques est incorporé dans la couche conductrice (10), le tissu de fils métalliques étant de préférence constitué du même métal que les particules métalliques (12) de la couche conductrice (10).

6. Actionneur multicouche selon une des revendications qui précèdent **caractérisé en ce que** la couche conductrice (10) présente une épaisseur de 0,01 à 1 mm ; le domaine de 0,1 à 0,3 mm étant particulièrement préféré.

7. Procédé de fabrication d'un actionneur multicouche monolithique (15) constitué d'un empilage de feuilles minces de piézocéramique frittées comportant des électrodes métalliques intérieures incorporées (7), toutes les électrodes intérieures (7) d'une polarité étant branchées électriquement en parallèle au moyen d'une métallisation de base (3, 4) appliquée sur l'empilage et une électrode extérieure (5) est reliée de façon électriquement conductrice dans le but d'établir un contact électrique avec la métallisation de base (3, 4), en vue de la réalisation d'un actionneur multicouche (15) selon une des revendications 1 à 6, **caractérisé en ce qu'**en tant qu'électrode extérieure (5) une pâte comportant des particules métalliques de forme sphérique (12) est appliquée et agglomérée par la chaleur sur la métallisation de base (3, 4) et **en ce que** pour la pâte on utilise des particules métalliques (12) de forme sphérique d'un diamètre de 10 à 50 micromètres, la pâte étant agglomérée par la chaleur à une température qui est suffisante pour déclencher une agglomération par frittage des particules métalliques (12) mais qui est cependant suffisamment basse pour éviter une densification des particules métalliques (12) en un corps solide, de telle manière que lors du processus d'agglomération par la chaleur la pâte se transforme en une couche conductrice (10), métallique, poreuse et ductile, qui est constituée de particules métalliques (12) frittées ensemble.

8. Procédé selon la revendication 7 **caractérisé en ce que** la pâte est appliquée sur la métallisation de base (3, 4) selon la technique d'impression au pochoir.

9. Procédé selon la revendication 7 ou 8 **caractérisé en ce qu'**on utilise en tant que pâte un mélange de particules de forme sphérique ( 12) et de liants et de solvants organiques, aucun élément susceptible de former du verre n'étant utilisé pour la pâte.

10. Procédé selon une des revendications 7 à 9 **caractérisé en ce qu'**au moins un tissu de fils métalliques est incorporé dans la pâte, le tissu de fils métalliques étant de préférence constitué du même métal que les particules métalliques (12) de la pâte.

11. Procédé selon une des revendications 7 à 10 **caractérisé en ce que** l'emplacement prévu sur la couche conductrice (10) sur lequel doit être soudé ultérieurement un fil conducteur d'arrivée (6), en vue d'établir un contact électrique, est rendu solide au moins superficiellement.
